# EUROPEAN PATENT SPECIFICATION

(11) **EP 1 477 538 B1**
(45) Date of publication and mention of the grant of the patent: **25.07.2007**
(21) Application number: 04011217.9
(22) Date of filing: 11.05.2004
(51) Int. Cl.: C09G 1/02

(54) **Chemical mechanical polishing agent kit and chemical mechanical polishing method using the same**
Chemisch-mechanisches Poliermittel-Kit und chemisch-mechanisches Polierverfahren unter Verwendung desselben
Kit de polissage mécano-chimique et méthode de polissage Mécano-chimique utilisant ce kit

(30) Priority: 12.05.2003 JP 2003132579
(43) Date of publication of application: 17.11.2004
(73) Proprietor: JSR Corporation, Tokyo (JP)
(72) Inventor: Shida, Hirotaka, Tokyo (JP); Konno, Tomohisa, Tokyo (JP); Hattori, Masayuki, Tokyo (JP); Kawahashi, Nobuo, Tokyo (JP)
(74) Representative: TBK-Patent

(56) References cited:
- EP-A- 1 116 762
- US-A- 6 046 110
- US-A- 6 083 840
- US-B1- 6 217 416

## Description

### FIELD OF THE INVENTION

The present invention relates to a chemical mechanical polishing agent kit comprising a chemical mechanical polishing aqueous dispersion containing abrasive grains and a chemical mechanical polishing aqueous composition containing an organic compound having a heterocyclic ring.

### BACKGROUND OF THE INVENTION

With densification of semiconductor devices, wirings formable in the devices have been made finer recently. Exemplary technologies capable of attaining much finer wirings include the damascene method. This method comprises steps of filling a trench or the like formed in an insulating substrate with a wiring material, and then removing an excess wiring material by chemical mechanical polishing to form desired wiring.

In the conventional chemical mechanical polishing, if wiring is formed by, for example, copper as a wiring material, the copper wiring portion is excessively polished and hence the copper wiring portion sometimes becomes concave. Such concave curve of the wiring is called "dishing" or "erosion", and this causes the yield loss of semiconductor devices.

If the polishing time is irreducibly minimized in order to make the dishing smaller, copper tends to remain on the surface of a barrier metal layer or the insulating substrate. If such a remainder is present, copper sometimes remains on the surface of the insulating substrate even after the barrier metal polishing, and this causes great lowering of the yield.

Moreover, there is another problem that occurrence of scratches on the wiring or the insulating substrate or occurrence of "corrosion" that is a phenomenon that the copper wiring portion is corroded during the polishing has a great influence on the yield.

In order to inhibit dishing or erosion to thereby enhance smoothness of the wafer surface or in order to prevent occurrence of scratches and corrosion, various polishing compositions have been heretofore proposed.

For example, Japanese Patent Laid-Open Publication No. 163141/1998 discloses that a composition for polishing a copper film comprising an abrasive, water and an iron(III) compound is effective in the inhibition of dishing or scratching. Japanese Patent Laid-Open Publication No. 160141/2000 discloses that a polishing composition comprising an abrasive, α-alanine, hydrogen peroxide and water is effective in the inhibition of dishing and erosion and that a polished surface having excellent smoothness is obtained. Japanese Patent Laid-Open Publication No. 44047/1998 discloses that a chemical mechanical polishing slurry containing an aqueous medium, an abrasive, an oxidizing agent and an organic acid can reduce imperfection, defect and corrosion of a surface to the minimum level. It also discloses that a surface active agent is effective for the improvement of smoothness of a wafer surface.

In the actual chemical mechanical polishing, in order to completely remove excess copper present on the barrier metal layer by polishing, it is necessary to further carry out polishing (over-polishing) even after the barrier metal layer is exposed. In this case, there resides a problem that dishing of a wide wiring portion is increased or corrosion of a copper wiring portion occurs during the over-polishing. Such a problem has caused great lowering of the yield. On this account, a method to completely prevent increase of dishing and occurrence of corrosion during the over-polishing has been desired. That is to say, development of a high-performance polishing method and a polishing agent used for the method has been desired from the viewpoint of enhancement of the yield in the polishing process.

Document EP-A-1 116 762 discloses an aqueous dispersion for chemical mechanical polishing of copper films, barrier metal films and insulating films on semiconductor substrates, as well as a chemical mechanical polishing process employing the aqueous dispersion. The aqueous dispersion is particularly useful for the second-stage chemical mechanical polishing step of two-stage polishing processes, or for the second-stage or third-stage chemical mechanical polishing step of three-stage polishing processes. The aqueous dispersion contains an abrasive, a heterocyclic compound, an organic acid and an oxidizing agent.

Document US 6 217 416 B1 discloses a first CMP slurry including an abrasive, an oxidizing agent, a complexing agent, a film forming agent and an organic amino compound, a second polishing slurry including an abrasive, an oxidizing agent and acetic acid wherein the ratio of the oxidizing agent to acetic acid is at least 10, and a method for using the first and second polishing slurries sequentially to polish a substrate containing copper and containing tantalum or tantalum nitride or both tantalum and tantalum and tantalum nitride.

### OBJECT OF THE INVENTION

The present invention is intended to solve such problems associated with the prior art as described above, and it is an object of the present invention to provide a polishing method capable of preventing increase of dishing and corrosion of wiring portion during the polishing to enhance the yield and a polishing agent used in the method.

### DISCLOSURE OF THE INVENTION

The present inventor has earnestly studied to solve the above problems and has found that increase of dishing and corrosion of wiring portion during an over-polishing can be prevented by conducting polishing using a chemical mechanical polishing aqueous dispersion (A) containing abrasive grains and then conducting polishing using a chemical mechanical polishing aqueous composition (B) containing at least one organic compound having a heterocyclic ring in addition to the chemical mechanical polishing aqueous dispersion (A). Based on the finding, the present invention has been accomplished.

A chemical mechanical polishing agent kit according to the present invention is defined according to claim 1. The chemical mechanical polishing aqueous composition (B) preferably further contains a surface active agent.

(i) The chemical mechanical polishing aqueous composition (B) contains no abrasive grain or contains abrasive grains in a concentration of not more than 1/2 the abrasive grain concentration of the chemical mechanical polishing aqueous dispersion (A), and (ii) the chemical mechanical polishing aqueous composition (B) contains the organic compound having a heterocyclic ring in a concentration of 0.005 to 3% by weight. It is preferable that the chemical mechanical polishing aqueous composition (B) further contains a surface active agent in a concentration of 0.005 to 1% by weight.

It is preferable that the chemical mechanical polishing aqueous dispersion (A) further contains an oxidizing agent, and the chemical mechanical polishing aqueous composition (B) contains no oxidizing agent or contains an oxidizing agent in a concentration of not more than 1/2 the oxidizing agent concentration of the chemical mechanical polishing aqueous dispersion (A).

It is preferable that the chemical mechanical polishing aqueous dispersion (A) contains the abrasive grains in a concentration of 0.01 to 5% by weight, an organic compound having a heterocyclic ring in a concentration of 0.01 to 5% by weight, a surface active agent in a concentration of 0.01 to 2% by weight and an oxidizing agent in a concentration of 0.01 to 9% by weight.

A chemical mechanical polishing method according to the present invention is defined according to claim 6 and is a method for chemical mechanical polishing of a metal layer formed on a surface of a semiconductor substrate, on said surface a metal wiring portion being present, in the production of the semiconductor substrate comprising the substrate having a trench and a metal material buried in the trench, said metal material forming the metal wiring portion.

### EFFECT OF THE INVENTION

The chemical mechanical polishing agent kit of the present invention and the chemical mechanical polishing method using the kit can inhibit increase of dishing and occurrence of corrosion during the over-polishing and can prevent lowering of the yield.

### BRIEF DESCRIPTION OF THE DRAWINGS

Fig. 1 is a group of views showing exemplary steps of a chemical mechanical polishing method according to the present invention.
Fig. 2 is a group of views showing exemplary steps of a chemical mechanical polishing method according to the present invention.
Fig. 3 is a graph showing a relationship between a ratio of the over-polishing time to the polishing time until endpoint and dishing.

Here are symbols in the Figures.
1 : metal material (metal wiring portion)
2 : substrate
2a: non-wiring portion
3a: barrier metal layer in a trench of the substrate
3b: barrier metal layer on the non-wiring area
4: metal layer

### PREFERRED EMBODIMENTS OF THE INVENTION

### <Chemical mechanical polishing agent kit>

The chemical mechanical polishing agent kit according to the invention comprises a combination of a chemical mechanical polishing aqueous dispersion (A) containing abrasive grains and a chemical mechanical polishing aqueous composition (B) which contains at least one organic compound having a heterocyclic ring and does not mix with the chemical mechanical polishing aqueous dispersion (A). In this chemical mechanical polishing agent kit, the chemical mechanical polishing aqueous dispersion (A) and the chemical mechanical polishing aqueous composition (B) are not mixed before the kit is used for chemical mechanical polishing, but when the kit is used for chemical mechanical polishing, the chemical mechanical polishing aqueous dispersion (A) is used singly, or is mixed with the chemical mechanical polishing aqueous composition (B) to use it. The word "mix" herein denotes that the aqueous dispersion (A) and the aqueous composition (B) are in the mixed state during the polishing. For example, the aqueous dispersion (A) and the aqueous composition (B) can be previously mixed and the mixture can be fed into a polishing apparatus, or the aqueous dispersion (A) and the aqueous composition (B) can be individually fed into a polishing apparatus and they can be mixed in the polishing apparatus or on a polishing pad.

### (A) Chemical mechanical polishing aqueous dispersion

The chemical mechanical polishing aqueous dispersion (A) is not specifically restricted in its composition provided that it is a chemical mechanical polishing aqueous dispersion for polishing a metal film, but the aqueous dispersion contains abrasive grains and preferably contains an organic compound having a heterocyclic ring, a surface active agent and an oxidizing agent when needed.

### (Abrasive grains)

The abrasive grains for use in the aqueous dispersion (A) are preferably inorganic particles or organic-inorganic composite particles. Examples of the inorganic particles include fumed silica, fumed alumina or fumed titania which is synthesized by the reaction of silicon chloride, aluminum chloride or titanium chloride with oxygen and hydrogen in a gas phase through a fumed process; silica synthesized by hydrolysis condensation of metal alkoxide through a sol-gel process; and high-purity colloidal silica synthesized by an inorganic colloid process and freed of impurities by purification.

The organic-inorganic composite particles are not specifically restricted in their type and constitution, provided that they are formed in such one united body that the organic particle and the inorganic particle should not be easily separated from each other in the polishing process. For example, there can be mentioned composite particles which are obtained by polycondensing alkoxysilane, aluminum alkoxide or titanium alkoxide in the presence of polymer particles, such as particles of polystyrene or polymethyl methacrylate, to form a polycondensate, such as polysiloxane, polyaluminoxane or polytitanoxane, on at least surfaces of the polymer particles. In these composite particles, the polycondensate thus formed may be directly bonded to a functional group of the polymer particle or may be bonded through a silane coupling agent.

The organic-inorganic composite particles may be formed by the use of the above-mentioned polymer particles and silica particles, alumina particles or titania particles. In this case, the composite particles may be formed so that the silica particles or the like are present on the surfaces of the polymer particles using the polycondensate, such as polysiloxane, polyaluminoxane or polytitanoxane, as a binder, or may be formed so that the functional group of the silica particle or the like, such as a hydroxyl group, is chemically bonded to the functional group of the polymer particle.

Further, composite particles wherein an organic particle and an inorganic particle which are different in the sign of a zeta-potential are bonded by the electrostatic force in an aqueous dispersion of these particles are also employable as the organic-inorganic composite particles.

The zeta-potential of the organic particle is frequently a negative potential over the whole pH region or a wide pH region except a region of low pH. When the organic particle has a carboxyl group or a sulfonic acid group, it tends to have a negative zeta-potential more certainly. When the organic particle has an amino group, it sometimes has a positive zeta-potential in a specific pH region.

On the other hand, the zeta-potential of the inorganic particle shows a high pH dependence, and the inorganic particle has an isoelectric point at which the zeta-potential is 0, so that the sign of the zeta-potential is reversed across that point depending upon pH.

Accordingly, by mixing specific organic particles with specific inorganic particles in a pH region where the signs of their zeta-potentials are opposite to each other, the organic particle and the inorganic particle are bonded by the electrostatic force and united to form a composite particle. Even if the signs of the zeta potentials are the same at the pH during the mixing, the sign of the zeta-potential of one of those particles, particularly an inorganic particle, can be made opposite by changing pH, whereby the organic particle and the inorganic particle can be united.

On at least surfaces ot the composite particles thus united by the electrostatic force, a polycondensate, such as polysiloxane, polyaluminoxane or polytitanoxane, may be further formed by polycondensing alkoxysilane, aluminum alkoxide or titanium alkoxide in the presence of these composite particles.

The abrasive grains preferably have an average particle diameter of 5 to 1000 nm. The average particle diameter can be determined by the use a laser scattering diffraction analyser or by observation using a transmission electron microscope. If the average particle diameter is less than 5 nm, a chemical mechanical polishing aqueous dispersion having a sufficiently high removal rate cannot be obtained in some cases. If the average particle diameter exceeds 1000 nm, inhibition of dishing and erosion sometimes becomes insufficient, and a stable aqueous dispersion cannot be readily obtained in some cases because of precipitation or separation of the abrasive grains. Although the average particle diameter of the abrasive grains may be in the above range, it is in the range of more preferably 10 to 700 nm, particularly preferably 15 to 500 nm. If the average particle diameter is in this range, a stable chemical mechanical polishing aqueous dispersion having a high removal rate, capable of sufficiently inhibiting dishing and erosion and rarely suffering precipitation or separation of the abrasive grains can be obtained.

If metal ions, such as iron, nickel and zinc, remain in a semiconductor device having been subjected to chemical mechanical polishing treatment, yield loss is frequently brought about. Therefore, even if these metal ions are contained in the abrasive grains, the amount of the metal ions is desirably in the range of usually not more than 10 ppm, preferably not more than 5 ppm, more preferably not more than 3 ppm, particularly preferably not more than 1 ppm. As a matter of course, it is preferable that the abrasive grains do not contain these metal ions.

The abrasive grains are contained in an amount of preferably 0.01 to 5% by weight, more preferably 0.02 to 4% by weight, based on the total amount of the chemical mechanical polishing aqueous dispersion (A). If the amount of the abrasive grains is less than 0.01% by weight, a satisfactory removal rate cannot be obtained in some cases. If the amount thereof exceeds 5% by weight, cost is increased, and besides stability of the aqueous dispersion (A) sometimes becomes insufficient.

### (Organic compound having heterocyclic ring)

The organic compound having a heterocyclic ring for use in the aqueous dispersion (A) is, for example, an organic compound having at least one heterocyclic ring selected from the group consisting of five-membered heterocyclic rings and six-membered heterocyclic rings having at least one nitrogen atom. Examples of the heterocyclic rings include five-membered heterocyclic rings, such as pyrrole structure, imidazole structure and triazole structure; and six-membered heterocyclic rings, such as pyridine structure, pyrimidine structure, pyridazine structure and pyrazine structure. These heterocyclic rings may form condensed rings. Examples of the condensed rings include indole structure, isoindole structure, benzimidazole structure, benzotriazole structure, quinoline structure, isoquinoline structure quinazoline structure, cinnoline structure, phthalazine structure, quinoxaline structure and acridine structure.

Of the organic compounds having such structures, preferable are organic compounds having pyridine structure, quinoline structure, benzimidazole structure or benzotriazole structure. As the organic compounds, quinolinic acid, quinaldinic acid, benzimidazole and benzotriazole are preferable, and quinolinic acid and quinaldinic acid are more preferable.

The organic compound having a heterocyclic ring is contained in an amount of preferably 0.01 to 5% by weight based on the total amount of the chemical mechanical polishing aqueous dispersion (A). If the amount of the organic compound having a heterocyclic ring is less than 0.01% by weight, a satisfactory removal rate cannot be obtained in some cases. When the organic compound having a heterocyclic ring is contained in an amount of 5% by weight, a sufficient effect is obtained. Therefore, in consideration of the economical efficiency, it is unnecessary to add the organic compound having a heterocyclic ring in an amount of more than 5% by weight.

### (Surface active agent)

The surface active agent for use in the aqueous dispersion (A) is, for example, a cationic surface active agent, an anionic surface active agent or a nonionic surface active agent.

Examples of the cationic surface active agents include aliphatic amine salts and aliphatic ammonium salts. Examples of the anionic surface active agents include fatty acid soap; carboxylates, such as alkyl ether carboxylates; sulfonates, such as alkylbenzenesulfonate, alkylnaphthalenesulfonate and α-olefin sulfonate; sulfates, such as higher alcohol sulfate and alkyl ether sulfate; and phosphates, such as alkylphosphate.

Examples of the nonionic surface active agents include ether type surface active agents, such as polyoxyethylene alkyl ether; ether-ester type surface active agents, such as polyoxyethylene ether of glycerol ester; ester type surface active agents, such as polyethylene glycol fatty acid ester, glycerol ester and sorbitan ester; acetylene glycol; ethylene oxide addition product of acetylene glycol; and acetylene alcohol.

The surface active agent is contained in an amount of preferably not more than 2% by weight, more preferably 0.01 to 2% by weight, based on the total amount of the chemical mechanical polishing aqueous dispersion (A). If the amount of the surface active agent is less than 0.01% by weight, dishing, erosion and the like cannot be sufficiently inhibited in some cases. If the amount of the surface active agent exceeds 2% by weight, decreasing of a removal rate is induced, and besides, foaming cannot be inhibited in some cases.

### (Oxidizing agent)

Examples of the oxidizing agents for use in the aqueous dispersion (A) include hydrogen peroxide; organic peroxides, such as peracetic acid, perbenzoic acid and tert-butyl hydroperoxide; permanganic acid compounds, such as potassium permanganate; bichromic acid compounds, such as potassium bichromate; halogenic acid compounds, such as potassium iodate; nitric acid compounds, such as nitric acid and iron nitrate; perhalogenic acid compounds, such as perchloric acid; persulfates, such as ammonium persulfate; and heteropolyacid. By the addition of these oxidizing agents, a removal rate can be more greatly improved.

Of the above oxidizing agents, hydrogen peroxide, organic peroxides and persulfates such as ammonium persulfate are particularly preferable because their decomposition products are harmless.

The oxidizing agent is contained in an amount of preferably 0.01 to 9% by weight, more preferably 0.02 to 6% by weight, particularly preferably 0.03 to 5% by weight, based on the total amount of the chemical mechanical polishing aqueous dispersion (A). If the amount of the oxidizing agent is less than 0.01% by weight, oxidation action of copper sometimes becomes insufficient, and a satisfactory removal rate cannot be obtained in some cases. When the oxidizing agent is contained in an amount of 9% by weight, a sufficient effect is obtained. Therefore, in consideration of the economical efficiency, it is unnecessary to add the oxidizing agent in an amount of more than 9% by weight.

### (Other additives)

The chemical mechanical polishing aqueous dispersion (A) can further contain various additives when needed, in addition to the above components. By the addition of various additives, dispersion stability can be further enhanced, a removal rate can be increased, and when the aqueous dispersion (A) is used for polishing two or more films having different hardness, a difference in the removal rate between these films can be controlled.

More specifically, by the addition of an organic acid or an inorganic acid, an aqueous dispersion (A) having a higher removal rate can be obtained. Examples of the organic acids include para-toluenesulfonic acid, dodecylbenzenesulfonic acid, isoprenesulfonic acid, gluconic acid, lactic acid, citric acid, tartaric acid, malic acid, glycolic acid, malonic acid, formic acid, oxalic acid, succinic acid, fumaric acid, maleic acid and phthalic acid. Examples of the inorganic acids include nitric acid, sulfuric acid and phosphoric acid. These acids may be used singly or in combination of two or more kinds. Further, amino acids, such as glycine, alanine and glutamic acid; and water-soluble polymers, such as urea, polyacrylamide, polyacrylic acid, polyvinyl pyrrolidone and hydroxyethyl cellulose are also employable when needed.

By adding an alkali to the aqueous dispersion (A) and thereby adjusting pH, a removal rate can be increased. In this case, it is preferable to appropriately adjust pH in a range where the abrasive grains are stably present by considering electrochemical properties of a surface to be polished, disperibility and stability of polymer particles and a removal rate. Examples of alkalis employable herein include organic bases, such as ethylenediamine, ethanolamine and tetramethylammonium hydroxide; and inorganic bases, such as hydroxides of alkali metals, specifically sodium hydroxide, potassium hydroxide, rubidium hydroxide and cesium hydroxide, and ammonia.

By appropriately selecting components of the chemical mechanical polishing aqueous dispersion (A) and if necessary adjusting pH to control a removal rate as described above, a chemical mechanical polishing aqueous dispersion (A) having desired polishing performance can be obtained.

### (B) Chemical mechanical polishing aqueous composition

The chemical mechanical polishing aqueous composition (B) is not specifically restricted in its composition provided that it is a chemical mechanical polishing aqueous composition containing at least one organic compound having a heterocyclic ring. The chemical mechanical polishing aqueous composition (B) can contain abrasive grains, a surface active agent and an oxidizing agent when needed, within limits not detrimental to the object of the present invention. Similarly to the case of the chemical mechanical polishing aqueous dispersion (A), by appropriately selecting components of the chemical mechanical polishing aqueous composition (B) and if necessary adjusting pH to control a removal rate, a chemical mechanical polishing aqueous composition (B) having desired polishing performance can be obtained.

### (Organic compound having heterocyclic ring)

Examples of the organic compounds having a heterocyclic ring for use in the aqueous composition (B) include the same compounds as previously exemplified for the aqueous dispersion (A). The organic compound having a heterocyclic ring contained in the aqueous composition (B) may be the same as or different from the organic compound having a heterocyclic ring contained in the aqueous dispersion (A). The organic compound having a heterocyclic ring is contained in an amount of usually 0.005 to 3% by weight based on the total amount of the chemical mechanical polishing aqueous composition (B). If the amount of the organic compound having a heterocyclic ring is less than 0.005% by weight, increase of dishing and erosion and occurrence of corrosion cannot be inhibited in some cases. When the organic compound having a heterocyclic ring is contained in an amount of 3% by weight, a sufficient effect is obtained. Therefore, in consideration of the economical efficiency, it is unnecessary to add the organic compound having a heterocyclic ring in an amount of more than 3% by weight.

### (Abrasive grains)

Although the chemical mechanical polishing aqueous composition (B) preferably contains no abrasive grain, the aqueous composition (B) may contain abrasive grains in an amount not detrimental to the object of the present invention. When the abrasive grains are contained, the abrasive grain concentration is preferably not more than 1/2 the abrasive grain concentration of the aqueous dispersion (A). When the aqueous composition (B) contains no abrasive grain or contains abrasive grains in the above-mentioned abrasive grain concentration, increase of dishing can be inhibited and corrosion will not occur. Hence, yield loss can be prevented.

Examples of the abrasive grains for use in the aqueous composition (B) include the same abrasive grains as previously exemplified for the aqueous dispersion (A). The abrasive grains contained in the aqueous composition (B) may be the same as or different from the abrasive grains contained in the aqueous dispersion (A).

### (Surface active agent)

Examples of the surface active agents for use in the aqueous composition (B) include the same surface active agents as previously exemplified for the aqueous dispersion (A). The surface active agent contained in the aqueous composition (B) may be the same as or different from the surface active agent contained in the aqueous dispersion (A). The surface active agent is contained in an amount of preferably 0.005 to 1% by weight based on the total amount of the chemical mechanical polishing aqueous composition (B). When the amount of the surface active agent is not less than 0.005% by weight, dishing, erosion and the like can be sufficiently inhibited, but the amount thereof is preferably not more than 1% by weight from the viewpoint that decreasing of a removal rate and foaming can be inhibited.

### (Oxidizing agent)

Although the chemical mechanical polishing aqueous composition (B) preferably contains no oxidizing agent, the aqueous composition (B) may contain an oxidizing agent in an amount not detrimental to the object of the present invention. When the oxidizing agent is contained, the oxidizing agent concentration is preferably not more than 1/2 the oxidizing agent concentration of the aqueous dispersion (A). When the aqueous composition (B) contains no oxidizing agent or contains an oxidizing agent in the above-mentioned oxidizing agent concentration, increase of dishing can be inhibited and corrosion will not occur. Hence, yield loss can be prevented.

Examples of the oxidizing agents for use in the aqueous composition (B) include the same oxidizing agents as previously exemplified for the aqueous dispersion (A). The oxidizing agent contained in the aqueous composition (B) may be the same as or different from the oxidizing agent contained in the aqueous dispersion (A).

### <Chemical mechanical polishing method>

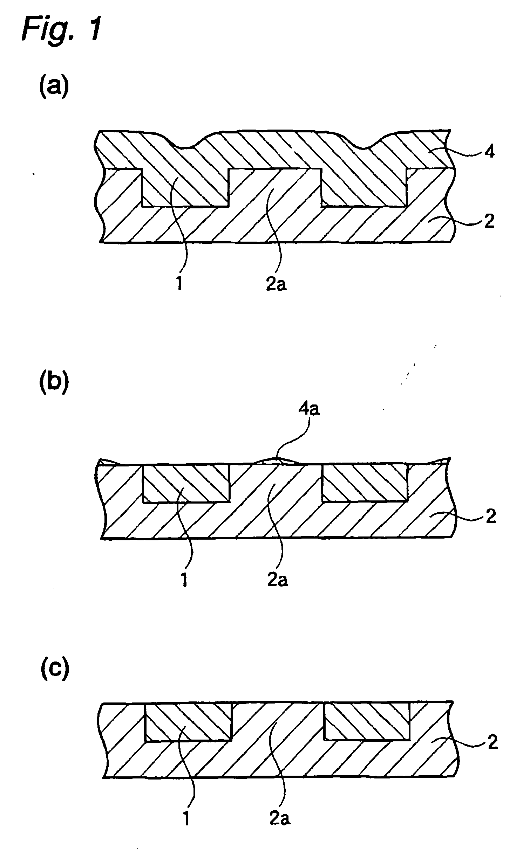

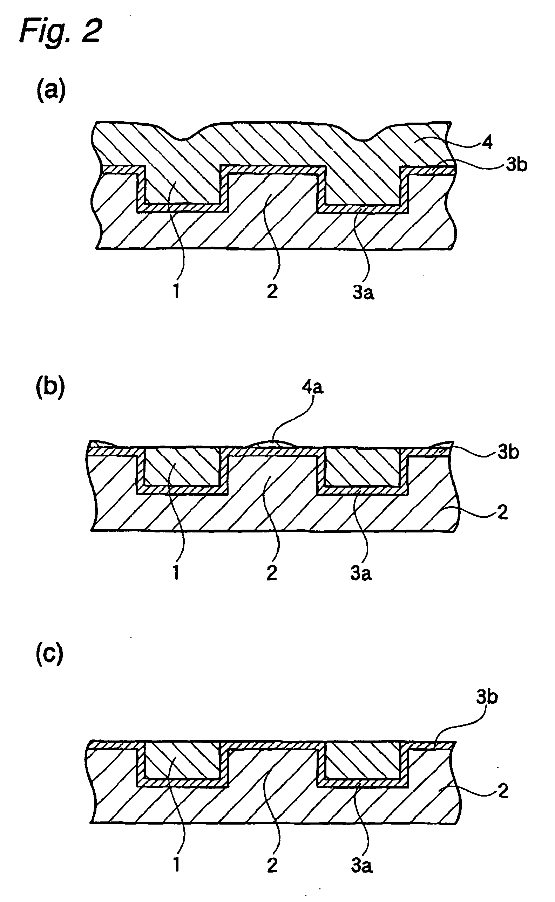

The chemical mechanical polishing method according to the invention is a method for chemical mechanical polishing of a metal layer formed on a surface of a semiconductor substrate, on said surface a metal wiring portion being present, in the production of the semiconductor substrate (Fig. 1(c) or 2(c)) comprising the substrate having a trench and a metal material buried in the trench, said metal material forming the metal wiring portion, which comprises polishing the metal layer with feeding the chemical mechanical polishing aqueous dispersion (A), and subsequently, polishing the metal layer remaining on the non-wiring area during the above polishing with feeding the chemical mechanical polishing aqueous composition (B) in addition to the chemical mechanical polishing aqueous dispersion (A). A barrier metal layer may be formed on the bottom and internal surface of the trench in the substrate and on the substrate surface in which the trench is present, when needed (Fig.2).

The semiconductor substrate having a metal layer on such a surface is, for example, a semiconductor substrate which is obtained in the production process of a semiconductor device such as super LSI and which has not been subjected to polishing treatment.

Examples of metals for forming the metal wiring portion and the metal layer include pure metals, such as pure tungsten, pure aluminum and pure copper; and alloys of tungsten, aluminum or copper and other metals. The material to constitute the non-wiring portion is not specifically restricted provided that it is a material having insulating properties, and is, for example, silicon oxide or an insulating resin. Examples of metals to constitute the barrier metal layer include tantalum, titanium, tantalum nitride and titanium nitride.

As a polishing apparatus, a commercially available chemical mechanical polishing apparatus (e.g., EPO-112 model and EPO-222 model manufactured by Ebara Corpration, LGP-510 model and LGP-552 model manufactured by Lap Master SFT Co., Mirra (trade name) manufactured by Applied Materials Inc.) is employable.

The chemical mechanical polishing method according to the invention is further described in more detail with reference to figures, but it should be construed that the invention is in no way limited to the figures. A semiconductor substrate material to be polished is a material wherein a metal layer 4 is formed on the surface of a semiconductor substrate, where a metal wiring portion is present (Fig. 1(a) or 2(a)). As shown in Fig: 1(a) or 2(a), the semiconductor substrate comprises a substrate 2 having a trench and a metal material 1 buried in the trench. The metal material forms a metal wiring portion.

First, such a semiconductor substrate as shown in Fig. 1(a) or 2(a) is set in a polishing apparatus, and the metal layer 4 is polished with feeding the chemical mechanical polishing aqueous dispersion (A). This polishing is conducted until the time (end point (Fig. 1(b) or 2(b)) at which a layer different from the metal layer 4 is exposed in a non-wiring area 2a other than the metal portion 1. The layer different from the metal layer 4 is the substrate 2a or the barrier metal layer 3b. This end point can be determined by measuring a value of a current that flows into a motor during the polishing and thereby detecting a change of torque or by detecting an eddy current by an eddy current method or by optically detecting a change of color of the surface to be polished.

The polishing conditions, such as type of polishing pad, carrier load, carrier rotating speed, table rotating speed and flow rate of the aqueous dispersion (A), are appropriately determined according to the material of the metal layer to be polished.

In the above polishing until the end point by the use of only the chemical mechanical polishing aqueous dispersion (A), the metal layer frequently remains on the non-wiring portion (Fig. 1(b) or 2(b)). Therefore, subsequently to the polishing until the end point, over-polishing is carried out for a predetermined time with feeding the chemical mechanical polishing aqueous composition (B) in addition to the chemical mechanical polishing aqueous dispersion (A) to remove the remaining metal layer 4a. The over-polishing time is appropriately determined on an experimental basis, and is preferably 0 to 50% of the polishing time until the end point. The polishing conditions, such as type of polishing pad, carrier load, carrier rotating speed, table rotating speed, flow rate of the aqueous dispersion (A) and flow rate of the aqueous composition (B), are appropriately determined according to the material of the metal layer to be polished. The flow rate of the aqueous dispersion (A) during the over-polishing is preferably not more than that during the polishing until the end point. The flow rate of the aqueous composition (B) is preferably 0.5 to 2 times the flow rate of the aqueous dispersion (A).

After the metal layer are polished as described above, abrasive grains remaining on the surface of the semiconductor substrate are preferably removed by, for example, a usual cleaning method.

As described above, polishing is carried out with feeding only the aqueous dispersion (A) until the substrate or the barrier metal layer is exposed, and then over-polishing is carried out with feeding the aqueous composition (B) in addition to the aqueous dispersion (A), whereby increase of dishing can be prevented, and polishing free from copper remaining can be attained. According to the chemical mechanical polishing method of the invention, further, flat and excellent metal semiconductor substrate can be obtained without occurrence of corrosion. Further according to the chemical mechanical polishing method of the invention, after the polishing until the end point by the use of only the aqueous dispersion (A), the aqueous composition (B) is just added, whereby polishing can be readily conducted and the above metal semiconductor substrate is obtained.

If polishing is carried out until the end point by the use of only the aqueous dispersion (A) and over-polishing is subsequently carried out for a predetermined time by the use of only the aqueous dispersion (A) in order to remove a remaining metal layer 4a, the metal wiring portion is polished during over-polishing, and hence dishing becomes large. Further, if the over-polishing time is shortened to inhibit increase of dishing, the remaining metal layer 4a cannot be sufficiently removed. Furthermore, if both of the polishing until the endpoint and the over-polishing are carried out with feeding only the aqueous composition (B), a removal rate is extremely low, and hence a metal semiconductor substrate cannot be readily produced.

### EXAMPLES

The present invention is further described with reference to the following examples, but it should be construed that the invention is in no way limited to those examples. The terms "part(s)" and "%" used in the examples and the comparative examples mean "part(s) by weight" and "% by weight", respectively, unless otherwise noted.

### Preparation Example 1

### (Preparation of fumed silica particle-containing aqueous dispersion)

100 Parts by weight of fumed silica particles (available from Nippon Aerosil Co., Ltd., trade name: AEROSIL #90) were dispersed in 900 parts by weight of ion-exchanged water by means of an ultrasonic dispersing machine, and the resulting dispersion was filtered through a filter having a pore size of 5 µm to prepare an aqueous dispersion (1) containing 10% by weight of fumed silica particles.

### Preparation Example 2

### (Preparation of colloidal silica-containing aqueous dispersion)

In a 2-liter flask, 70 parts by weight of ammonia water having a concentration of 25% by weight, 40 parts by weight of ion-exchanged water, 175 parts by weight of ethanol and 21 parts by weight of tetraechoxysilane were poured, and they were heated to 60°C with stirring at 180 rpm. At this temperature, stirring was continued for 2 hours, and then cooling was achieved to obtain an alcohol dispersion containing colloidal silica having an average particle diameter of 97 nm. Then, from the dispersion, an alcohol was removed by means of an evaporator with adding ion-exchanged water at 80°C. This operation was repeated several times to sufficiently remove an alcohol from the dispersion. Thus, an aqueous dispersion (2) containing 10% by weight of colloidal silica having an average particle diameter of 97 nm was prepared.

### Preparation Example 3

### (Preparation of aqueous dispersion containing abrasive grains comprising composite particles)

In a 2-liter flask, 90 parts by weight of methyl methacrylate, 2 parts by weight of methoxypolyethyleneglycol methacrylate (available from Shin-nakamura Chemical Co., Ltd., trade name: NK ester M-90G #400) 5 parts by weight of 4-vinylpyridine, 2 parts by weight of an azo type polymerization initiator (available from Wako Pure Chemical Industries, Ltd., trade name: V50) and 400 parts by weight of ion-exchanged water were placed, and they were heated to 70°C with stirring in a nitrogen gas atmosphere. At this temperature, polymerization was performed for 6 hours to obtain an aqueous dispersion containing polymethyl methacrylate particles having an average particle diameter of 150 nm, wherein the particles have a functional group having a cation of an amino group and a polyethylene glycol chain. The polymerization yield was 95%. In a 2-liter flask, 100 parts by weight of this aqueous dispersion containing 10% by weight of polymethyl methacrylate particles were poured, and 1 part by weight of methyltrimethoxysilane was added, followed by stirring at 40°C for 2 hours. Thereafter, 50 parts by weight of aqueous dispersion containing 10 % by weight of colloidal silica (available from Nissan Chemical Industries, Ltd., trade name: Snowtex O) was stepwise added over a period of 2 hours to mix them. The mixture was further stirred for 2 hours to give an aqueous dispersion containing particles wherein silica particles had adhered onto the polymethyl methacrylate particles. Then, to the aqueous dispersion, 2 parts by weight of vinyltriethoxysilane were added, and they were stirred for 1 hour. Thereafter, 1 part by weight of tetraethoxysilane was further added, and the dispersion was heated to 60°C, followed by stirring for 3 hours. Then, the dispersion was cooled to give an aqueous dispersion (3) containing 10% by weight of composite particles. The composite particles had an average particle diameter of 180 nm and were particles wherein silica particles had adhered onto 80% of surfaces of the polymethyl methacrylate particles.

### Examples 1 to 6

### (1) Preparation of chemical mechanical polishing aqueous dispersion (A)

In a 10-liter polyethylene container, a given amount of ion-exchanged water was placed, and to the water, a compound having a heterocyclic ring and a surface active agent shown in Table 1 were added so as to give concentrations shown in Table 1, followed by sufficient stirring. With stirring of the mixture, an oxidizing agent shown in Table 1 was added so as to give an oxidizing agent concentration shown in Table 1. Then, the aqueous dispersion obtained in the above preparation example was added so as to give an abrasive grain concentration shown in Table 1, followed by sufficient stirring. Thereafter, the resulting dispersion was filtered through a filter having a pore size of 5 µm to give a chemical mechanical polishing aqueous dispersion (A).

### (2) Preparation of chemical mechanical polishing aqueous composition (B)

In a manner similar to that in the preparation (1) of the chemical mechanical polishing aqueous dispersion (A), components shown in Table 1 were added to ion-exchanged water so as to obtain concentrations shown in Table 1. Thus, a chemical mechanical polishing aqueous composition

### (B) was obtained.

### (3) Polishing of wafer having copper wiring pattern

A commercially available wafer having a copper wiring pattern (SEMATECH #831, metal wiring portion and metal layer: Cu, non-wiring portion: SiO₂, barrier metal layer: Ta) was set on a polishing apparatus (Ebara Corporation, model: EPO112), and the wafer was polished under the following conditions with feeding the chemical mechanical polishing aqueous dispersion (A) at a flow rate shown in Table 2. An end point was regarded as the time at which the copper layer on the non-wiring region of the wafer was removed, namely, the time at which the barrier metal layer on the non-wiring area was exposed, and the end point was determined by detecting a change of a table current value (change of torque).

### (Polishing conditions)

Polishing pad: available from Rodel Inc. (U.S.A.), trade name: IC1000-050-(603)-(P)-S400J
Carrier load: 200 g/cm²
Carrier rotating speed: 80 rpm
Table rotating speed: 100 rpm

Subsequently to the above polishing until the end point, the wafer was over-polished (subsequent polishing) under the same polishing conditions as described above with feeding the chemical mechanical polishing aqueous composition (B) in addition to the chemical mechanical polishing aqueous dispersion (A) at flow rates shown in Table 2. The over-polishing time was regarded as 20% of the polishing the time until the end point.

### (4) Evaluation of dishing

With regard to the 100 µm wiring portion of the wafer having been subjected to the polishing (3), a distance (difference in height) between the plane formed by the insulating film or the barrier metal layer and the lowest point of the wiring portion was measured by the use of an accurate difference meter HRP (manufactured by KLA Tencor Co.) to evaluate dishing. The results are set forth in Table 2.

### (5) Evaluation of copper remaining

The 0.35 µm wiring portion of the wafer having been subjected to the polishing (3) was all observed by a light microscope to examine presence of copper remaining. The results are set forth in Table 2.

### (6) Evaluation of corrosion

With regard to the 0.35 µm wiring portion of the wafer having been subjected to the polishing (3), an edge portion of the copper wiring was observed by a scanning electron microscope to examine presence of corrosion. The results are set forth in Table 2.

### Comparative Example 1

Using the chemical mechanical polishing aqueous dispersion (A) used in Example 1, the wafer was polished to the end point in the same manner as in Example 1. Then, the wafer was over-polished in the same manner as in Example 1, except that only the chemical mechanical polishing aqueous dispersion (A) was fed at a flow rate shown in Table 3. The resulting wafer was evaluated in the same manner as in Example 1. The results are set forth in Table 3.

### Comparative Example 2

### (1) Preparation of chemical mechanical polishing aqueous composition (b)

In a 10-liter polyethylene container, a given amount of ion-exchanged water was placed, and with stirring of the water, hydrogen peroxide was added so as to give a concentration shown in Table 1. Then, the aqueous dispersion (2) obtained in the aforesaid preparation example was added so as to give an abrasive grain concentration of 0.01%, followed by sufficient stirring. Thereafter, the resulting dispersion was filtered through a filter having a pore size of 5 µm to give a chemical mechanical polishing aqueous composition (b).

### (2) Polishing of wafer having copper wiring pattern

Using the chemical mechanical polishing aqueous dispersion (A) used in Example 1, the wafer was polished to the end point in the same manner as in Example 1. Then, the wafer was over-polished in the same manner as in Example 1, except that the chemical mechanical polishing aqueous composition (b) were fed in addition to the chemical mechanical polishing aqueous dispersion (A) at flow rates shown in Table 3. The resulting wafer was evaluated in the same manner as in Example 1. The results are set forth in Table 3.

### Comparative Example 3

Using the chemical mechanical polishing aqueous dispersion (A) used in Example 1, the wafer was polished to the end point in the same manner as in Example 1. The resulting wafer was evaluated in the same manner as in Example 1. The results are set forth in Table 3.

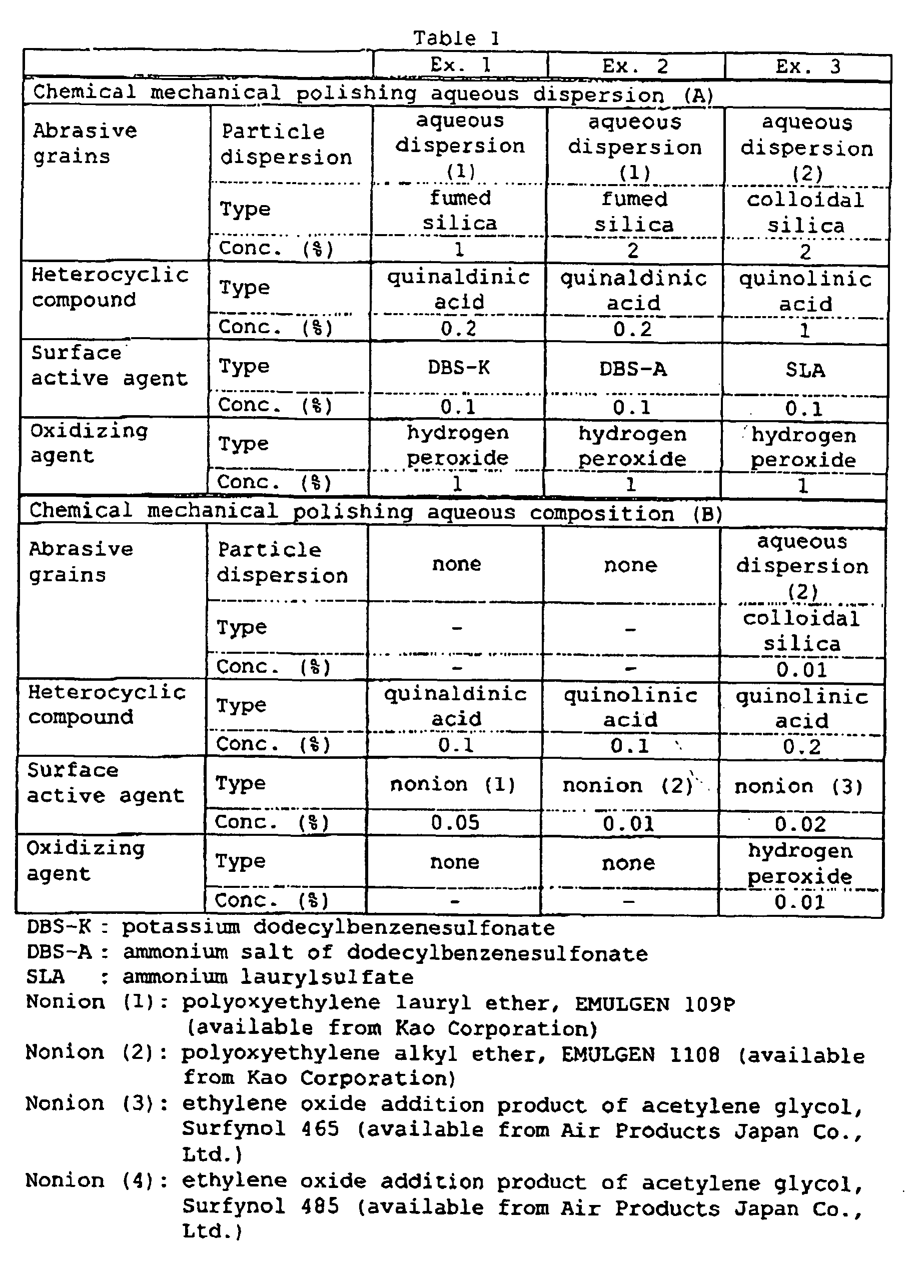

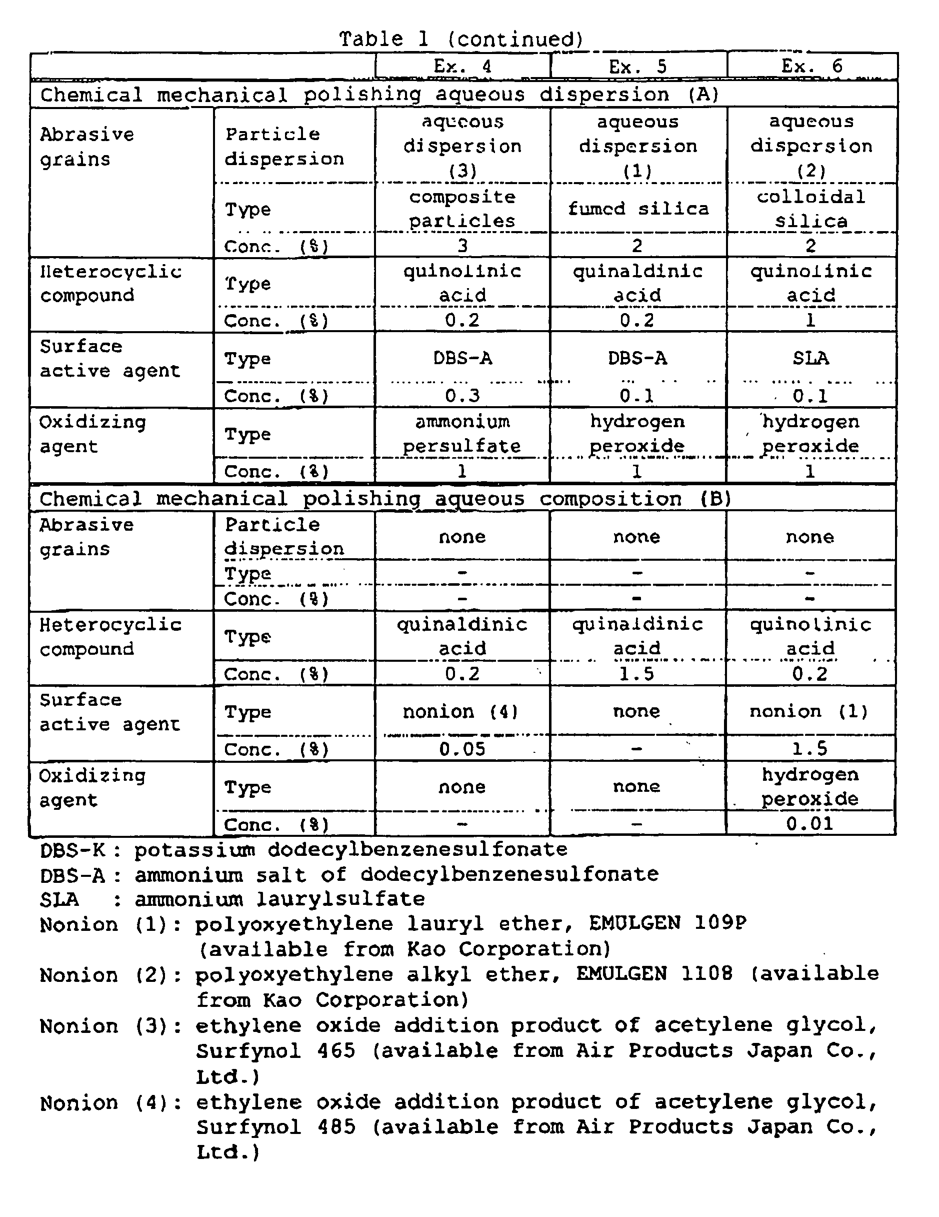

**Table 2**

| | | Ex. 1 | Ex. 2 | Ex. 3 | Ex. 4 | Ex. 5 | Ex. 6 |
|---|---|---|---|---|---|---|---|
| Polishing until end point | Flow rate of aqueous dispersion (A) (mL/min) | 200 | 150 | 300 | 250 | 150 | 300 |
| | Polishing time (sec) | 185 | 125 | 175 | 108 | 125 | 175 |
| Over-polishing | Flow rate of aqueous dispersion (A) (mL/min) | 200 | 150 | 300 | 50 | 150 | 300 |
| | Flow rate of aqueous composition (B) (mL/min) | 200 | 200 | 300 | 400 | 200 | 150 |
| | Over-olishing time (sec) | 37 | 25 | 35 | 22 | 25 | 35 |
| Wafer evaluation | 100 µm dishing (Å) | 800 | 940 | 960 | 680 | 1200 | 850 |
| | Cu remaining (Light microscope observation) | none | none | none | none | none | none |
| | Corrosion (SEM observation) | none | none | none | none | none | none |

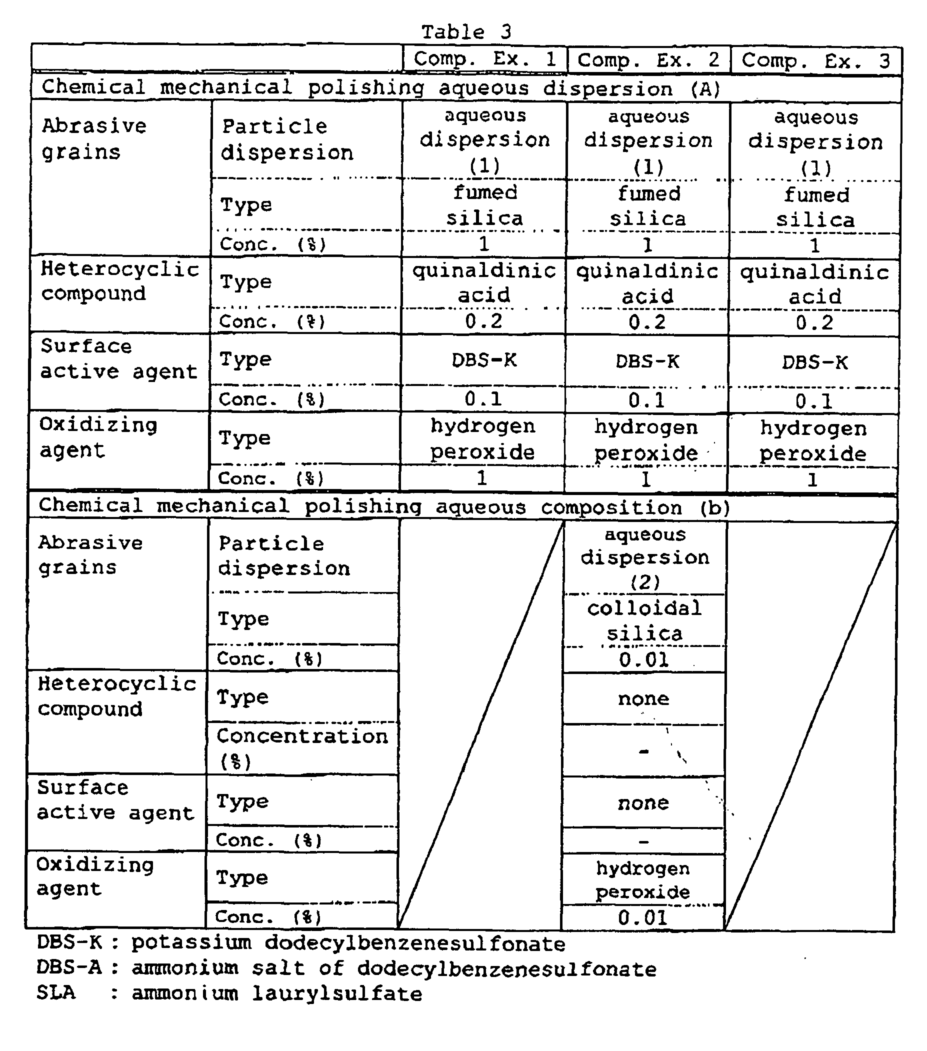

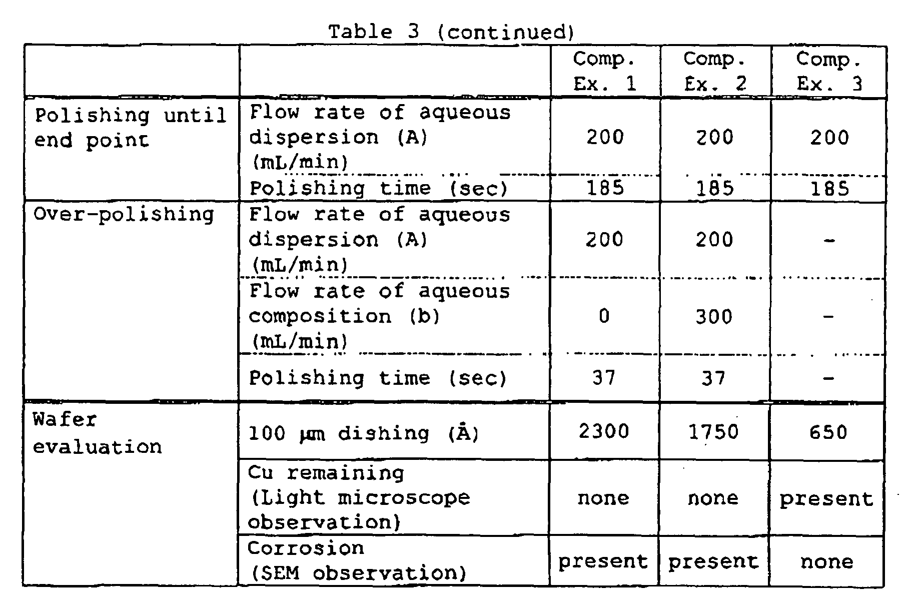

As can be seen from the results in Table 1 and Table 2, when the chemical mechanical polishing aqueous composition (B) were used in addition to the chemical mechanical polishing aqueous dispersion (A) during the over-polishing, dishing was small, copper remaining and corrosion did not take place, and good results were exhibited. Generally, dishing of not more than 1500 Å is preferable, and a wafer having dishing of more than 1500 Å is often judged as fail.

On the other hand, it can be seen that when the wafer was polished by the use of only the chemical mechanical polishing aqueous dispersion (A) without using the chemical mechanical polishing aqueous composition (B) during the over-polishing, dishing was large and corrosion took place (Comparative Example 1).

Further, it can be seen that when the wafer was polished by the use of the chemical mechanical polishing aqueous composition (b) containing no heterocyclic compound instead of the chemical mechanical polishing aqueous composition (B) containing a heterocyclic compound during the over-polishing, dishing and corrosion both took place (Comparative Example 2).

Furthermore, it can be seen that when the over-polishing was not carried out, copper remaining took place though dishing was good (Comparative Example 3).

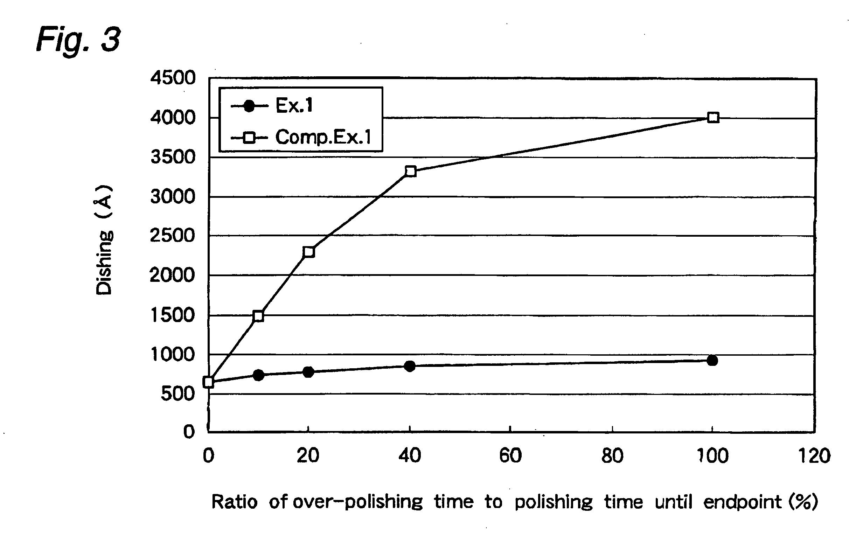

In Fig. 3, a relationship between a ratio of the over-polishing time to the polishing time until the end point and dishing is shown. It can be seen from Fig. 3 that increase of dishing during the over-polishing was inhibited by the use of the chemical mechanical polishing aqueous composition (B).

### INDUSTRIAL APPLICABILITY

The chemical mechanical polishing agent kit of the present invention is useful for the production of semiconductor devices. In more detail, the chemical mechanical polishing agent kit can be favorably used in the process for forming wiring of a semiconductor device requiring mixed mounting of extremely fine wiring of about 0.05 µm to wide wiring of about 100 µm, such as high-speed logic LSI, more specifically, in a polishing step of the process.

According to the chemical mechanical polishing method of the present invention, increase of dishing and occurrence of corrosion can be prevented, and a semiconductor device requiring mixed mounting of extremely fine wiring of about 0.05 µm to wide wiring of about 100 µm, such as high-speed logic LSI, can be produced.

## Claims

1. A chemical mechanical polishing agent kit comprising a combination of
a chemical mechanical polishing aqueous dispersion (A) containing abrasive grains and
a chemical mechanical polishing aqueous composition (B) which contains at least one organic compound having a heterocyclic ring, wherein the aqueous composition (B) does not mix with the aqueous dispersion (A), and wherein
(i) the chemical mechanical polishing aqueous composition (B) contains no abrasive grain or contains abrasive grains in a concentration of not more than 1/2 the abrasive grain concentration of the chemical mechanical polishing aqueous dispersion (A), and
(ii) the chemical mechanical polishing aqueous composition (B) contains the organic compound having a heterocyclic ring in a concentration of 0.005 to 3% by weight.

2. The chemical mechanical polishing agent kit as claimed in claim 1, wherein the chemical mechanical polishing aqueous composition (B) further contains a surface active agent.

3. The chemical mechanical polishing agent kit as claimed in claim 2, wherein the chemical mechanical polishing aqueous composition (B) contains said surface active agent in a concentration of 0.005 to 1% by weight.

4. The chemical mechanical polishing agent kit as claimed in claim 1, wherein the chemical mechanical polishing aqueous dispersion (A) further contains an oxidizing agent, and the chemical mechanical polishing aqueous composition (B) contains no oxidizing agent or contains an oxidizing agent in a concentration of not more than 1/2 the oxidizing agent concentration of the chemical mechanical polishing aqueous dispersion (A).

5. The chemical mechanical polishing agent kit as claimed in any one of claims 1 to 4, wherein the chemical mechanical polishing aqueous dispersion (A) contains the abrasive grains in a concentration of 0.01 to 5% by weight, an organic compound having a heterocyclic ring in a concentration of 0.01 to 5% by weight, a surface active agent in a concentration of 0.01 to 2% by weight and an oxidizing agent in a concentration of 0.01 to 9% by weight.

6. A method for chemical mechanical polishing of a metal layer formed on a surface of a semiconductor substrate, on said surface a metal wiring portion being present, in the production of the semiconductor substrate comprising the substrate having a trench and a metal material buried in the trench, said metal material forming the metal wiring portion, which comprises:
polishing the metal layer with feeding the chemical mechanical polishing aqueous dispersion (A) as defined in claim 1 until a layer different from the metal layer is exposed in a non-wiring area other than the metal portion, and
subsequently, polishing the metal layer remaining on the non-wiring area during the above polishing with feeding the chemical mechanical polishing aqueous composition (B) as defined in claim 1 in addition to the chemical mechanical polishing aqueous dispersion (A).

## Patentansprüche

1. Kit mit Mittel für das chemisch-mechanische Polieren, umfassend eine Kombination aus
einer wässrigen Dispersion (A) für das chemisch-mechanische Polieren, die Schleifkörner enthält, und
eine wässrige Zusammensetzung (B) für das chemisch-mechanische Polieren, die mindestens eine organische Verbindung mit einem heterocyclischen Ring enthält, wobei sich die wässrige Zusammensetzung (B) nicht mit der wässrigen Dispersion (A) mischt, und wobei
(i) die wässrige Zusammensetzung (B) für das chemisch-mechanische Polieren kein Schleifkorn enthält, oder Schleifkörner in einer Konzentration von nicht mehr als 1/2 mal die Schleifkorn-Konzentration der wässrigen Dispersion (A) für das chemisch-mechanische Polieren enthält, und
(ii) die wässrige Zusammensetzung (B) für das chemisch-mechanische Polieren die organische Verbindung mit einem heterocyclischen Ring in einer Konzentration von 0,005 bis 3 Gew.-% enthält.

2. Kit mit Mittel für das chemisch-mechanische Polieren nach Anspruch 1, wobei die wässrige Zusammensetzung (B) für das chemisch-mechanische Polieren weiter einen oberflächenaktiven Stoff enthält.

3. Kit mit Mittel für das chemisch-mechanische Polieren nach Anspruch 2, wobei die wässrige Zusammensetzung (B) für das chemisch-mechanische Polieren den oberflächenaktiven Stoff in einer Konzentration von 0,005 bis 1 Gew.-% enthält.

4. Kit mit Mittel für das chemisch-mechanische Polieren nach Anspruch 1, wobei die wässrige Dispersion (A) für das chemisch-mechanische Polieren weiter ein Oxidationsmittel enthält, und die wässrige Zusammensetzung (B) für das chemisch-mechanische Polieren kein Oxidationsmittel enthält, oder ein Oxidationsmittel in einer Konzentration von nicht mehr als 1/2 mal die Konzentration des Oxidationsmittels der wässrigen Dispersion (A) für das chemisch-mechanische Polieren enthält.

5. Kit mit Mittel für das chemisch-mechanische Polieren nach einem der Ansprüche 1 bis 4, wobei die wässrige Dispersion (A) für das chemisch-mechanische Polieren die Schleifkörner in einer Konzentration von 0,01 bis 5 Gew.-%, eine organische Verbindung mit einem heterocyclischen Ring in einer Konzentration von 0,01 bis 5 Gew.-%, einen oberflächenaktiven Stoff in einer Konzentration von 0,01 bis 2 Gew.-% und ein Oxidationsmittel in einer Konzentration von 0,01 bis 9 Gew.-% enthält.

6. Verfahren für das chemisch-mechanische Polieren einer Metallschicht, erzeugt auf einer Oberfläche eines Halbleitersubstrats, wobei auf der Oberfläche ein metallischer Leitungs-Teil vorhanden ist, in der Herstellung des Halbleitersubstrats, umfassend das Substrat mit einem Graben und einem in dem Graben eingegrabenen metallischen Material, wobei das metallische Material den metallischen Leitungs-Teil bildet, welches Verfahren umfasst:
Polieren der Metallschicht mit Zuführen der wässrigen Dispersion (A) für das chemisch-mechanische Polieren, wie in Anspruch 1 definiert, bis eine Schicht, die anders als die Metallschicht ist, freigesetzt wird in einer nicht-leitenden Fläche, die anders als der metallische Teil ist, und
nachfolgend ein Polieren der Metallschicht, die auf der nicht-leitenden Fläche verbleibt, während des obigen Polierens mit einem Zuführen der wässrigen Zusammensetzung (B) für das chemisch-mechanische Polieren, wie in Anspruch 1 definiert, zusätzlich zu der wässrigen Dispersion (A) für das chemisch-mechanische Polieren.

## Revendications

1. Kit d'agent de polissage mécano-chimique comprenant une combinaison de
une dispersion aqueuse de polissage mécano-chimique (A) contenant des grains abrasifs et
une composition aqueuse de polissage mécano-chimique (B) qui contient au moins un composé organique ayant un hétérocycle, dans lequel la composition aqueuse (B) ne se mélange pas avec la dispersion aqueuse (A), et dans lequel
(i) la composition aqueuse de polissage mécano-chimique (B) ne contient pas de grains abrasifs ou contient des grains abrasifs dans une concentration de pas plus de 1/2 de la concentration de grains abrasifs de la dispersion aqueuse de polissage mécano-chimique (A), et
(ii) la composition aqueuse de polissage mécano-chimique (B) contient le composé organique ayant un hétérocycle dans une concentration de 0,005 à 3% en poids.

2. Kit d'agent de polissage mécano-chimique selon la revendication 1, dans lequel la composition aqueuse de polissage mécano-chimique (B) contient en outre un agent actif de surface.

3. Kit d'agent de polissage mécano-chimique selon la revendication 2, dans lequel la composition aqueuse de polissage mécano-chimique (B) contient ledit agent actif de surface dans une concentration de 0,005 à 1% en poids.

4. Kit d'agent de polissage mécano-chimique selon la revendication 1, dans lequel la dispersion aqueuse de polissage mécano-chimique (A) contient en outre un agent oxydant, et la composition aqueuse de polissage mécano-chimique (B) ne contient pas d'agent oxydant ou contient un agent oxydant dans une concentration de pas plus de 1/2 de la concentration d'agent oxydant de la dispersion aqueuse de polissage mécano-chimique (A).

5. Kit d'agent de polissage mécano-chimique selon l'une quelconque des revendications 1 à 4, dans lequel la dispersion aqueuse de polissage mécano-chimique (A) contient les grains abrasifs dans une concentration de 0,01 à 5% en poids, un composé organique ayant un hétérocycle dans une concentration de 0,01 à 5% en poids, un agent actif de surface dans une concentration de 0,01 à 2% en poids et un agent oxydant dans une concentration de 0,01 à 9% en poids.

6. Procédé de polissage mécano-chimique d'une couche de métal formée sur une surface d'un substrat semiconducteur, sur ladite surface une portion de câblage en métal étant présente, dans la production du substrat semiconducteur comprenant le substrat ayant une tranchée et un matériau de métal enterré dans la tranchée, ledit matériau de métal formant la portion de câblage en métal, qui comprend :
le polissage de la couche de métal en apportant la dispersion aqueuse de polissage mécano-chimique (A) selon la revendication 1 jusqu'à ce qu'une couche différente de la couche de métal soit exposée dans une zone sans câblage autre que la portion de métal, et
subséquemment le polissage de la couche de métal restant sur la zone sans câblage lors du polissage ci-dessus en apportant la composition aqueuse de polissage mécano-chimique (B) selon la revendication 1 en plus de la dispersion aqueuse de polissage mécano-chimique (A).
